# EUROPÄISCHE PATENTSCHRIFT

(11) **EP 0 258 628 B1**
(45) Veröffentlichungstag und Bekanntmachung des Hinweises auf die Patenterteilung: **21.09.1994**
(21) Anmeldenummer: 87110929.4
(22) Anmeldetag: 28.07.1987
(51) Int. Cl.: H01H 85/44, H04Q 1/14

(54) **Baugruppe zum Sichern von elektrischen Leitungen in Verteilern von Telekommunikationsanlagen**
Module for protecting electrical lines in distributing devices for telecommunication installations
Module pour protéger les lignes électriques dans des répartiteurs d'installations de télécommunication

(30) Priorität: 25.08.1986 DE 3628843; 25.08.1986 DE 3628809; 25.08.1986 DE 3628807
(43) Veröffentlichungstag der Anmeldung: 09.03.1988
(73) Patentinhaber: SIEMENS AKTIENGESELLSCHAFT, 80333 München (DE)
(72) Erfinder: Scholtholt, Hans, Ing.-(grad.), D-8044 Lohhof (DE); Steiner, Ewald, Ing.-(grad.), D-8137 Berg 3 (DE)

(56) Entgegenhaltungen:
- DE-B- 1 171 017
- FR-A- 2 302 582
- FR-A- 2 341 974
- GB-A- 2 117 577

## Beschreibung

Die Erfindung bezieht sich auf eine Baugruppe zum Sichern von elektrischen Leitungen in Verteilern von Telekommunikations-, insbesondere Fernsprechanlagen, wobei die an einen Schichtbaustein des Verteilers anschaltbare Baugruppe mit aneinandergereihten Überspannungsableitern als Querglied gegen Erde und Stromsicherungen als Längsglied bestückt ist.

Eine derartige Baugruppe ist durch die DE-PS 32 12 013 bekannt geworden. Die Stromsicherungen und die Überspannungsableiter sind an ihren Polen von Kontaktstücken gehalten, die an einem Trägerteil der Baugruppe befestigt sind. Die Kontaktstücke enden in Kontaktflächen, die entlang einer Längskante der Baugruppe angeordnet sind und die mit Steckkontakten von Kontaktfedern des Schichtbausteines kontaktiert sind. Das Trägerteil ist als Spritzgußteil ausgebildet, in das die Kontaktstücke eingelassen sind. Die Kontaktstücke erstrecken sich ebenso wie die Stromsicherungen im wesentlichen senkrecht zur Reihenrichtung. Die röhrchenförmigen Stromsicherungen sind an ihren Enden zwischen hochgebogenen Kontaktteilen der Kontaktstücke gehalten, die sich von den Kontaktflächen aus zu beiden Seiten des Trägerteils der Baugruppe erstrecken. Die Kontaktteile sind aus den Kontaktstücken um eine in Längsrichtung der Sicherung liegende Biegekante herausgebogen.

Es ist aus der Zeichnung erkennbar, daß ein Pol der Stromsicherung dem zugehörigen Überspannungsableiter unmittelbar benachbart ist. Dieser Pol ist mit einem Pol des Überspannungsableiters unmittelbar durch die Federschenkel des zugehörigen Kontaktstückes zusammengeschaltet. Der andere Pol des Überspannungsableiters liegt an einem hochgebogenen Lappen eines streifenförmigen Erdungsvielfaches an, das mit einer Erdungsfeder einer Aufnahme für die Schichtbausteine und den Baugruppen kontaktiert ist.

Ferner ist es durch die DE-PS 25 08 845 bekannt, Baugruppen ohne Stromsicherungen zu verwenden, bei denen senkrecht zum Trägerteil stehende Überspannungsableiter mit ihren geerdeten Polen an Federfingern eines U-förmig gebogenen Erdungsbleches anliegen. Der andere Pol des Überspannungsableiters steht auf einem flachen Schmelzstück, das an einer Kontaktzone des Kontaktstückes anliegt. Das Kontaktstück weist eine U-förmig hochgebogene Auskröpfung auf, deren höchster Punkt bis in die unmittelbare Nähe der Enden der Federfinger reicht. Beim Schmelzen des Schmelzstückes senkt sich der Federfinger so weit ab, daß das Kontaktstück unmittelbar an Erde gelegt wird.

Der Erfindung liegt die Aufgabe zugrunde, eine mit Stromsicherungen und Überspannungsableitern bestückte Baugruppe bei geringem Mehraufwand mit einer derartigen Kurzschlußmöglichkeit auszustatten.

Diese Aufgabe wird durch die Erfindung gemäß Anspruch 1 gelöst. Da der Federfinger in die unmittelbare Nähe des Kontaktteiles für die Stromsicherung ragt, kann z. B. auf die hochgebogene Auskröpfung in raumsparender Weise verzichtet werden. Beim Schmelzen des Schmelzstückes legt sich der Federfinger unmittelbar an das Kontaktteil für die Stromsicherung an, so daß der entsprechende Leitungszug unmittelbar an Erde liegt.

Vorteilhafte Weiterbildungen der Erfindung sind in den Ansprüchen 2 bis 7 gekennzeichnet:

Durch die Weiterbildung nach Anspruch 2 ist es möglich, die doppelseitige Anordnung der Leiterbahnen auf einer gedruckten Leiterplatte kostengünstig zu realisieren. Durch die senkrechte Anordnung der Überspannungsableiter können diese raumsparend versetzt zueinander mit geringem Teilungsabstand angeordnet werden. Die Kontaktzonen für die Überspannungsableiter sind als einfache Erweiterungen der Leiterbahnen ausgebildet. Die Überspannungsableiter mit den Schmelzstücken sind zwischen der Leiterplatte und den Federfingern eingeklemmt gehalten.

Durch die Weiterbildung nach Anspruch 3 wird zwischen dem Kontaktteil und dem Federfinger ein Doppelkontakt mit entsprechend höherer Kontaktsicherheit ermöglicht.

Durch die Weiterbildung nach Anspruch 4 läßt sich das Erdungsvielfach ohne zusätzliche Befestigungsmittel in einfacher Weise an der Baugruppe befestigen. Da die Federfinger nicht nur die Überspannungsableiter, sondern auch die überspannungsgefährdeten Kontaktteile für die Stromsicherungen überdecken, wird auch der Berührungsschutz der Baugruppe erhöht.

Durch die Weiterbildung nach Anspruch 5 werden die Vorteile eines Spritzgußteils mit denen einer gedruckten Leiterplatte verbunden. Die Baugruppe kann zwecks besserer Herstellung und Bestückung sowie Handhabung optimal gestaltet werden.

Durch die Weiterbildungen nach den Ansprüchen 6 und 7, können mit Hilfe von unterschiedlichen Kontaktteilen ohne sonstige Änderungen unterschiedliche Stromsicherungen für die Baugruppe verwendet werden.

Im folgenden wird die Erfindung anhand von in der Zeichnung dargestellten Ausführungsbeispielen näher erläutert. Es zeigen:
- FIG 1: einen seitlichen Schnitt durch eine Baugruppe zum Sichern von elektrischen Leitungen in Verteilern von Fernsprechvermittlungsanlagen,
- FIG 2: eine Draufsicht auf die Baugruppe nach FIG 1,
- FIG 3: eine Seitenansicht eines Teiles der Baugruppe nach FIG 1,
- FIG 4: die Baugruppe nach FIG 1 mit anderen Kontaktteilen und anderen Stromsicherungen,
- FIG 5: eine Draufsicht auf die Baugruppe nach FIG 4,
- FIG 6: eine Seitenansicht eines Kontaktteils der Baugruppe nach FIG 4,
- FIG 7: eine Draufsicht auf das Kontaktteil nach FIG 6,
- FIG 8: einen Teil der Baugruppe nach FIG 4 mit einer Stromsicherung unmittelbar vor dem Einsetzen.

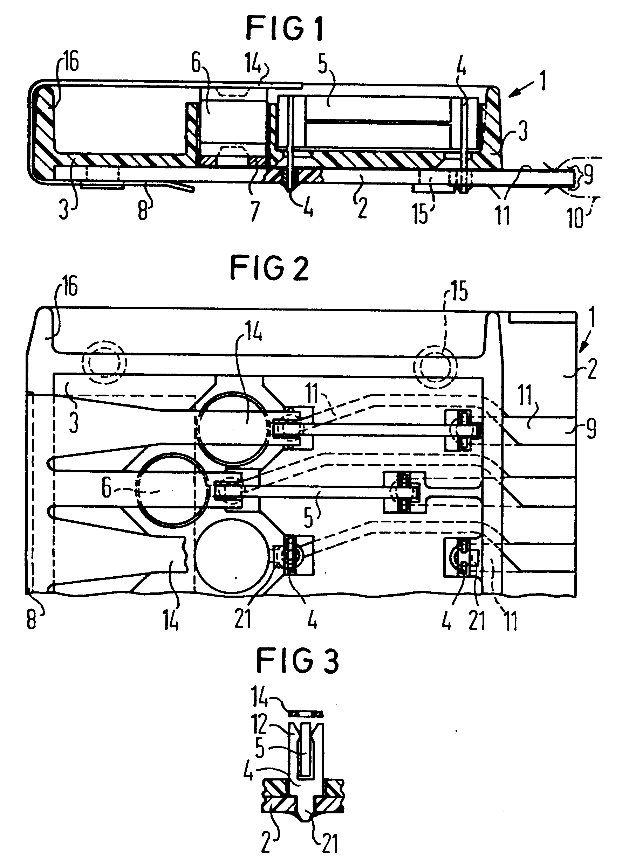

Nach den Figuren 1, 2 und 3 besteht eine Baugruppe 1 aus einer doppelseitig kaschierten Leiterplatte 2, einem Gehäuseteil 3, Kontaktteilen 4, Stromsicherungen 5, Überspannungsableitern 6, Schmelzstücken 7 und einem Erdungsvielfach 8. Die Leiterplatte 2 ist entlang einer ihrer Längskanten zu beiden Seiten mit Kontaktflächen 9 für Kontaktfedern 10 eines Schichtbausteines in einem Verteiler einer Fernsprechvermittlungsanlage versehen. Die beiden übereinander liegenden Kontaktfedern 10 sind über Leiterbahnen 11 der Leiterplatte 2, die Kontaktteile 4 und die Stromsicherungen 5 miteinander elektrisch verbunden. Eine der Leiterbahnen 11 ist auf der den Stromsicherungen 5 und Überspannungsableitern 6 zugewandten Seite der Leiterplatte 2 angeordnet und über die entsprechende Kontaktfeder 10 mit einer Ader einer nach außen führenden Teilnehmerleitung verbunden. Diese Leiterbahn erstreckt sich bis unter den Überspannungsableiter 6 wo sie eine erweiterte Kontaktzone für das Schmelzstück 7 bildet, das zwischen dem Überspannungsableiter 6 und der Kontaktzone gehalten ist. Diese Leiterbahn 11 ist dabei über ein durchkontaktiertes Lötauge geführt, das der Kontaktzone für den Überspannungsableiter 6 unmittelbar benachbart ist. In dieses Lötauge ist eines der Kontaktteile 4 für die Stromsicherung eingelötet. Das andere Kontaktteil 4 ist in ein den Kontaktflächen 9 benachbartes Lötauge eingelötet, das mit der auf der anderen Seite der Leiterplatte 2 liegenden Leiterbahn verbunden ist.

Die flachen Kontaktteile 4 sind gabelartig ausgebildet und halten zwischen Federschenkeln 12 die Stromsicherungen 5 an deren Polen. Sie sind senkrecht stehend mit einem Lötdorn 13 in die durchkontaktierten Bohrungen der Leiterplatte 2 eingelötet. Die über der Leiterplatte 2 senkrecht stehenden, zueinander versetzten Überspannungsableiter 6 sind zwischen Federfingern 14 des gefiederten Erdungsvielfaches 8 und den Schmelzstücken 7 gehalten. Die Federfinger 14 erstrecken sich bis über die freie Stirnseite der benachbarten, zueinander versetzten Kontaktteile 4. Der Abstand zwischen den Federfingern 14 und den Kontaktteilen 4 ist kleiner als die Dicke des Schmelzstückes 7. Beim Abschmelzen desselben legt sich der Federfinger 14 an das Kontaktteil 4 an, so daß der Leitungszug unmittelbar an Erde gelegt wird. Die Federfinger 14 sind an ihren freien Enden über den Kontaktteilen 4 geschlitzt, so daß sich zu diesen ein Doppelkontakt ergibt.

Das Erdungsvielfach 8 ist als U-förmig gebogenes Blechteil ausgebildet, das sich mit einem Schenkel an die Leiterplatte 2 anlegt und die Baugruppe 1 umgreift.

Das aus Spritzguß hergestellte Gehäuseteil 3 ist auf die Leiterplatte 2 aufgesetzt und mit diesem durch Warmprägen von hervorstehenden Zapfen 15 verbunden, die durch Bohrungen der Leiterplatte 2 hindurchragen. Das Gehäuseteil 3 bildet Aufnahmen für die Überspannungsableiter 6 und die Stromsicherungen 5, es ist mit einem umlaufenden Schutzrand 16 versehen, der die Baugruppe mechanisch stabilisiert. Außerdem sind an dem Gehäuseteil 3 nicht dargestellte Griffteile zur besseren Handhabung der Baugruppe angebracht.

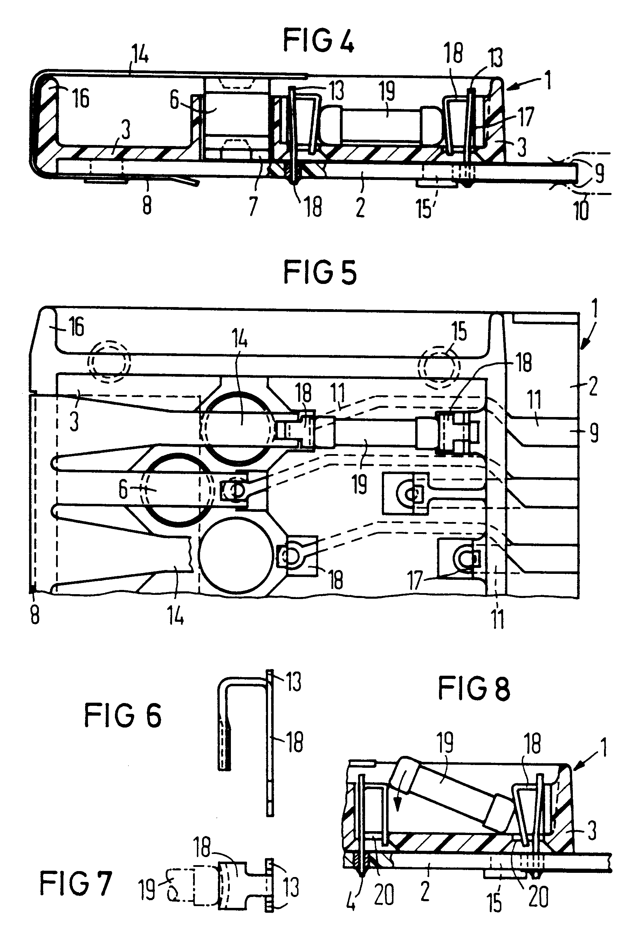

Nach den Figuren 4 und 5 ist die Baugruppe 1 anstelle der flachen Kontaktteile 4 (Figur 1) mit U-förmig gebogenen Kontaktteilen 18 versehen, die mit einem Schenkel in ein Lötauge der Leiterplatte 2 eingelötet sind. Die auslenkbaren freien Federschenkel sind einander paarweise zugewandt und klemmen jeweils eine röhrchenförmige kürzere Stromsicherung 19 stirnseitig ein. Die freien Schenkel der Kontaktteile 18 verlaufen zur Trägerplatte hin auseinandergespreizt und drücken dadurch die Stromsicherung 19 gegen die Basis des Gehäuseteils 3. Der Abstand der beiden Schenkel des Kontaktteils 18 ist der Länge der Stromsicherung 19 angepaßt. Das Kontaktteil 18 liegt mit seinem der Leiterplatte abgewandten Ende auf der der Stromsicherung gegenüberliegenden Seite an einer Anschlagschulter 17 des Gehäuseteils 3 an. Dadurch wird der Federweg verringert und die Klemmkraft erhöht. Die entsprechend der Lage der Überspannungsableiter 6 zueinander versetzten Kontaktteile 18 weisen in der Verlängerung des eingelöteten Schenkels von der Leiterplatte 2 wegweisende überstehende Lappe 13 auf, die gegenüber den Federfingern 14 die gleiche Funktion haben wie die flachen Kontaktteile nach FIG 1.

Nach den Figuren 6 und 7 ist der freie Federschenkel des Kontaktteils 18 in seiner Längsrichtung zur Stromsicherung 19 hin konkav gewölbt, wodurch diese in ihrer Seitenlage gesichert wird.

Nach Figur 8 wird die Stromsicherung 19 zunächst mit einem Ende schräg stehend gegen das Kontaktteil 18 gedrückt. Dieses hat eine so große Federreserve, daß es genügend weit ausgelenkt wird, um die andere Stirnseite der Stromsicherung 19 an den Basisabschnitt des anderen Kontaktteils 18 vorbeigleiten zu lassen. Dieses liegt mit seinem freien Schenkelende an einer Öffnung 20 an, die ein zu starkes Zurückfedern des vorgespannten freien Federschenkels verhindert.

## Patentansprüche

1. Baugruppe (1) zum Sichern von elektrischen Leitungen in Verteilern von Telekommunikations-, insbesondere Fernsprechanlagen, wobei die an einen Schichtbaustein des Verteilers anschaltbare Baugruppe (1) mit aneinandergereihten Überspannungsableitern (6) als Querglied gegen Erde und Stromsicherungen (5,19) als Längsglied bestückt ist, wobei die Stromsicherungen (5,19) an ihren beiden Polen mit Kontaktteilen (4,18) kontaktiert sind, von denen das dem zugehörigen Überspannungsableiter (6) benachbarte Kontakteil mit einem Pol des Überspannungsableiters (6) und dessen anderer Pol mit einem Erdungsvielfach (8) verbunden ist,
**dadurch gekennzeichnet,**
daß das Erdungsvielfach (8) mit Federfingern (14) an dem mit einem Schmelzstück (7) versehenen Überspannungsableiter (6) anliegt, daß die Federfinger (14) die Überspannungsableiter (6) bis in die Nähe der zugehörigen Kontaktteile (4,18) überragt und daß die in der Bewegungsrichtung der Federn bestehenden Abstände zwischen den Kontaktteilen (4, 18) und den Federfinger (14) kleiner sind als das Schmelzstück (7) dick sind.

2. Baugruppe nach Anspruch 1,
**dadurch gekennzeichnet,**
daß das Kontaktteil (4,18) senkrecht stehend in eine doppelt kaschierte Leiterplatte (2) eingelötet ist, daß der zugehörige Überspannungsableiter (6) mit seiner Mittelachse senkrecht zur Leiterplatte (2) steht, daß die Federfinger (14) an dem der Leiterplatte abgewandten Pol des Überspannungsableiters (6) anliegt und mit seinem freien Ende unmittelbar über dem freien Ende des Kontaktteiles (4) steht.

3. Baugruppe nach Anspruch 1 oder 2,
**dadurch gekennzeichnet,**
daß die Federfinger (14) an ihren freien Enden geschlitzt sind.

4. Baugruppe nach Anspruch 2 oder 3,
**dadurch gekennzeichnet,**
daß das Erdungsvielfach (8) als U-förmig gebogenes Blechteil ausgebildet und über der Rückseite der Baugruppe (1) an diese angeklammert ist.

5. Baugruppe nach einem der vorhergehenden Ansprüche,
**dadurch gekennzeichnet,**
daß auf die Leiterplatte (2) ein Gehäuseteil (3) aus Kunststoff aufgesetzt ist, das Ausnehmungen zur Aufnahme der Überspannungsableiter (6) und/oder Stromsicherungen (5,19) aufweist.

6. Baugruppe nach einem der vorhergehenden Ansprüche,
**dadurch gekennzeichnet,**
daß das flache Kontaktteil (4) zur Aufnahme der plättchenartigen Stromsicherung (5) eine gabelartige Stanzkontur aufweist.

7. Baugruppe nach einem der Ansprüche 1-5,
**dadurch gekennzeichnet,**
daß U-förmig gebogene Kontaktteile (18) für röhrchenförmige Stromsicherungen (19) mit einem Schenkel in die Leiterplatte (2) eingelötet sind und in der Verlängerung dieses Schenkels überstehende Lappen (13) aufweisen, die sich unter den freien Enden der Federschenkel (14) befinden.

## Claims

1. Assembly (1) for protecting electrical lines in distributors of telecommunication installations, preferably telephone installations, in which the assembly (1), which can be connected to a stacked module of the distributor, is equipped with rows of surge arresters (6) as shunt element to ground and fuses (5, 19) as series element, in which the fuses (5, 19) are contacted at their two poles by contact elements (4, 18), of which the contact element (4, 18) adjacent to the associated surge arrester (6) is connected to one pole of the surge arrester (6), and the other pole of which is connected to a ground bus (8), characterized in that with spring fingers (14) the ground bus (8) abuts the surge arrester (6) provided with a fusible component (7), in that the spring fingers (14) project beyond the surge arresters (6) into the vicinity of the associated contact elements (4, 18), and in that the spacings between the contact elements (4, 18) and the spring fingers (14) in the direction of movement of the springs are less than the thickness of the fusible components (7).

2. Assembly according to Claim 1, characterized in that the contact element (4, 18) is soldered into a double-sided circuit board (2) so that it stands upright, in that the central axis of the associated surge arrester (6) is perpendicular to the circuit board (2), and in that the spring fingers (14) abut the pole of the surge arrester (6) remote from the circuit board and stands with its free end directly above the free end of the contact element (4, 18).

3. Assembly according to Claim 1 or 2, characterized in that the spring fingers (14) are slit at their free ends.

4. Assembly according to Claim 2 or 3, characterized in that the ground bus (8) is designed as a sheet metal part bent into a U-shape and is clamped to the assembly (1) via the rear side thereof.

5. Assembly according to one of the preceding claims, characterized in that placed on the circuit board (2) is a housing component (3) made of synthetic material which has recesses for accommodating the surge arresters (6) and/or fuses (5, 19).

6. Assembly according to one of the preceding claims, characterized in that the flat contact element (4) has a fork-like stamped contour for accommodating the lamellar fuse (5).

7. Assembly according to one of Claims 1-5, characterized in that contact elements (18) bent into a U-shape for tubular fuses (19) are soldered by one leg into the circuit board (2) and have projecting tabs (13) in the extension of said leg which are located below the free ends of the spring legs (14).

## Revendications

1. Module (1) pour protéger des lignes électriques dans des répartiteurs d'installations de télécommunication, notamment de téléphonie, le module (1), qui peut être connecté à un composant pour couche du répartiteur, étant muni de limiteurs (6) de tension disposés en série en tant qu'élément transversal par rapport à la terre et de protection (5, 19) en courant en tant qu'élément longitudinal, les protections (5, 19) en courant étant en contact par leurs deux pôles avec des pièces (4, 18) de contact, parmi lesquelles la pièce (4, 18) de contact disposée au voisinage du limiteur (6) de tension correspondant est reliée à un pôle du limiteur (6) de tension, dont l'autre pole est relié à un connecteur (8) multiple de mise à la terre,
caractérisé en ce que
le connecteur (8) multiple de mise à la terre comportant des lames souples (14) est adjacent au limiteur (6) de tension muni d'une pièce fusible (7), les lames souples (14) surplombent les limiteurs (6) de tension jusqu'au voisinage des pièces (4, 18) de contact correspondantes et les intervalles formés, dans la direction de mouvement des lames souples, entre les pièces (4,18) de contact et les lames souples (14) sont plus petits que l'épaisseur des pièces fusibles (7).

2. Module selon la revendication 1, caractérisé en ce que la pièce (4,18) de contact est soudée perpendiculairement à une carte (2) à circuit imprimé bicouche, le limiteur de tension (6) correspondant est disposé de façon que son axe médian soit perpendiculaire à la carte (2) à circuit imprimé, les lames souples (14) sont adjacentes au pôle du limiteur de tension (6) qui est éloigné de la carte à circuit imprimé et sont disposées de façon que leurs extrémités libres soient situées directement au-dessus des extremités libres des pièces de contact.

3. Module selon la revendication 1 ou 2, caractérisé en ce que les lames souples (14) sont fendues à leurs extrémités libres.

4. Module selon la revendication 2 ou 3, caractérisé en ce que le connecteur (8) multiple de mise à la terre est réalisé sous la forme d'une pièce de tôle recourbée en U et est fixée au module (1) par l'arrière de celui-ci.

5. Module selon l'une quelconque des revendications précédentes, caractérisé en ce qu'un boîtier (3) en matière plastique est placé sur la carte (2) à circuit imprimé et présente des évidements destinés à recevoir les limiteurs (6) de tension et/ou les protections (5, 19) en courant.

6. Module selon l'une quelconque des revendications précédentes, caractérisé en ce que la pièce (4) de contact plane présente un contour découpé ayant la forme d'une fourche pour la réception d'une protection (5) en courant ayant la forme d'une plaquette.

7. Module selon l'une quelconque des revendications 1 à 5, caractérisé en ce que des pièces (18) de contact recourbées en U pour des protections (19) en courant tubulaires sont soudées, par une branche, dans la carte (2) à circuit imprimé et comportent des languettes (13) se prolongeant au-dessus de cette branche et situées sous les extrémités libres de la lame (14) souple.
